# EUROPÄISCHE PATENTSCHRIFT

(11) **EP 2 775 312 B1**
(45) Veröffentlichungstag und Bekanntmachung des Hinweises auf die Patenterteilung: **04.08.2021**
(21) Anmeldenummer: 14153172.3
(22) Anmeldetag: 30.01.2014
(51) Int. Cl.: G01R 31/28, G01R 31/327, H03K 17/18

(54) **Schaltungsanordnung**
Switching assembly
Circuit

(30) Priorität: 04.03.2013 DE 102013102094
(43) Veröffentlichungstag der Anmeldung: 10.09.2014
(73) Patentinhaber: Phoenix Contact GmbH & Co. KG, 32825 Blomberg (DE)
(72) Erfinder: Peter, Henry, 37574 Einbeck (DE); Rohs, Markus, 32825 Blomberg (DE); Eilers, Markus, 31812 Bad Pyrmont (DE); Pott, Thomas, 33604 Bielefeld (DE)
(74) Vertreter: Patentship Patentanwaltsgesellschaft mbH

(56) Entgegenhaltungen:
- EP-A2- 0 782 273
- GB-A- 2 171 544
- US-A- 3 872 473
- US-A- 4 470 039
- US-A- 4 761 762
- US-A- 5 387 899
- US-A- 6 121 874
- None

## Beschreibung

Die Erfindung betrifft eine Schaltungsanordnung zur Überwachung einer Mehrzahl von Signaleingängen.

In einer Automatisierungseinrichtung besteht eine Sicherheitskette aus einem Sensor (Nothalt), einer Logik (Sicherheitsschaltgerät) und einem Aktor, wie z.B. einem Schütz und Motor. Für bestimmte Sicherheitsintegritätslevel, wie z.B. gemäß EN 61 508, und/oder Kategorien, wie z.B. gemäß EN ISO 13849, wird eine zweikanalige Struktur gefordert. In diskret aufgebauten Schaltungen für die funktionale Sicherheit, insbesondere Relaisschaltungen, wird für die Plausibilität der Diagnose (Fehlerauswertung) der Sensoreingangsschaltung (zweikanaliger Nothalt, Lichtgitter, Schütztürschalter) meist einer oder mehrere Relaiskontakte verwendet. Wenn mit einer derartigen Sicherheitsschaltung mehrere Eingänge überwacht werden sollen steigt der Aufwand stark an.

Die Druckschrift GB 2 171 544 A offenbart eine elektronische Schaltungsanordnung zur Bestimmung einer Schalterposition eines mehrkanaligen Schalters.

Die Druckschrift US 4 761 762 A offenbart ein System, um eine Statusänderung von einer Mehrzahl von parallel geschalteten Schaltern abzufragen.

Die Druckschrift US 3 872 473 A offenbart eine Vorrichtung mit einer Mehrzahl von in Reihe geschalteten Schaltern, die als Signaleingänge ausgebildet sind und deren Status jeweils überprüft wird.

Die Druckschrift US 4 470 039 A offenbart ein System zum Testen eines Alarmsystems ohne das Alarmsystem selbst deaktivieren zu müssen.

Es ist daher Aufgabe der vorliegenden Erfindung, hier den Aufwand zu reduzieren.

Diese Aufgabe wird durch den Gegenstand mit den Merkmalen nach dem unabhängigen Anspruch gelöst. Vorteilhafte Ausführungsformen sind Gegenstand der abhängigen Ansprüche, der Beschreibung und der Zeichnungen.

Die vorliegende Erfindung basiert auf der Erkenntnis, dass sich mit einer Diagnoseschaltung zur Überwachung einer Mehrzahl von Signaleingängen der Diagnoseaufwand reduziert.

Gemäß einem ersten Aspekt wird die Aufgabe dadurch gelöst, dass eine Schaltungsanordnung zur Überwachung einer Mehrzahl von Signaleingängen eine Diagnosebaugruppe und eine Startbaugruppe aufweist, wobei die Startbaugruppe auf Erfassen eines deaktivierten Eingangssignals an einem der Signaleingänge durch die Schaltungsanordnung ein Startsignal erzeugend ausgebildet ist, die Startbaugruppe mit der Diagnosebaugruppe das Startsignal zu der Diagnosebaugruppe übertragend verbunden ist, und auf Erfassen des Startsignals die Diagnosebaugruppe aktivierbar ist. Dadurch wird der technische Vorteil erreicht, dass auf einen abfallenden Signaleingang hin durch die Startbaugruppe die Diagnosebaugruppe aktiviert wird, um eine Diagnose (Fehlerauswertung) durchzuführen. Somit ist eine einfache und effiziente Überprüfung einer Mehrzahl von Signaleingängen möglich.

In einer vorteilhaften Ausführungsform weist die Diagnosebaugruppe ein Schaltelement auf, das sich zumindest bei einem deaktivierten Signaleingang in einem ersten, aktiven Schaltzustand befindet, und sich sonst in einem zweiten, deaktivierten Schaltzustand befindet. Dadurch wird der technische Vorteil erreicht, dass die Diagnosebaugruppe durch das Schaltelement nur bei einem deaktivierten Signaleingang aktiviert wird.

In einer weiteren vorteilhaften Ausführungsform weist das Schaltelement einen Optokoppler auf. Dadurch wird der technische Vorteil erreicht, dass als Schaltelement leicht verfügbare, zuverlässig funktionierende und preiswerte Bauelemente verwendet werden können. So wird eine zuverlässige und preiswerte Schaltungsanordnung bereitgestellt.

In einer weiteren vorteilhaften Ausführungsform befindet sich bei einem entladenen Energiespeicher das Schaltelement in einem ersten, aktivierten Schaltzustand. Dadurch wird der technische Vorteil erreicht, dass ein Energiespeicher als Energiequelle genutzt werden kann, insbesondere wenn das Schaltelement sich im ersten, aktivierten Schaltzustand befindet.

In einer weiteren vorteilhaften Ausführungsform ist der elektrische Energiespeicher sich bei einem deaktivierten Signaleingang entladend ausgebildet. Dadurch wird der technische Vorteil erreicht, dass ein deaktivierter Signaleingang einen Entladevorgang eines elektrischen Energiespeichers auslöst, und so Energie für den weiteren Diagnosevorgang zur Verfügung gestellt ist.

In einer weiteren vorteilhaften Ausführungsform ist der Energiespeicher ein Kondensator. Dadurch wird der technische Vorteil erreicht, dass die Schaltungsanordnung aus leicht verfügbaren, zuverlässig funktionierenden und preiswerten Bauelementen, wie einem Kondensator, gebildet ist. So wird eine zuverlässige und preiswerte Schaltungsanordnung bereitgestellt.

In allen Ausführungsformen weist die Startbaugruppe eine UND-Baugruppe mit einem UND-Gatter mit einer Mehrzahl von Eingängen auf. Dadurch wird der technische Vorteil erreicht, dass eine Mehrzahl von Eingängen durch ein logischen UND verknüpft wird, so dass bei einem deaktivierten Signaleingang eines der Mehrzahl der Eingänge die UND-Baugruppe dies bereits anzeigt. So wird eine besonders einfache Überwachung einer Mehrzahl von Signaleingängen möglich.

In einer weiteren vorteilhaften Ausführungsform ist die Diagnosebaugruppe mit einer Selbsthalteschaltung elektrisch leitend verbunden, um die Schaltungsanordnung in Selbsthaltung zu halten. Dadurch wird der technische Vorteil erreicht, dass auch nur ein temporär deaktivierter Signaleingang der Mehrzahl der Signaleingänge einen Diagnosevorgang auslöst.

In einer weiteren vorteilhaften Ausführungsform sind die Signaleingänge einer Eingangsbaugruppe der Schaltungsanordnung zugeordnet, und die Eingangsbaugruppe ist mit einem Signaleingang der Diagnosebaugruppe elektrisch leitend verbunden. Dadurch wird der technische Vorteil erreicht, dass durch die Eingangsbaugruppe an den Signaleingängen anliegende Eingangssignale aufbereitet werden können, bevor sie der Diagnosebaugruppe zugeführt werden. Somit ist die Betriebssicherheit gesteigert.

In allen Ausführungsformen ist eine Einschaltverhinderungsbaugruppe vorgesehen, die ein Signal zum Verhindern eines Wiedereinschalten der Schaltungsanordnung bei aktivierter Diagnosebaugruppe bereitstellt. Dadurch wird der technische Vorteil erreicht, dass während eines Überprüfungsvorgangs durch die Diagnosebaugruppe eine Wiederinbetriebnahme nicht erfolgen kann und somit Störungen der Automatisierungseinrichtung durch die Schaltungsanordnung ausgeschlossen sind.

Weitere Ausführungsbeispiele werden Bezug nehmend auf die beiliegenden Zeichnungen erläutert. Es zeigen:
- Fig. 1: eine schematische Darstellung einer Schaltungsanordnung, und
- Fig. 2: einen schematischen Schaltplan eines Abschnitts der Startbaugruppe.

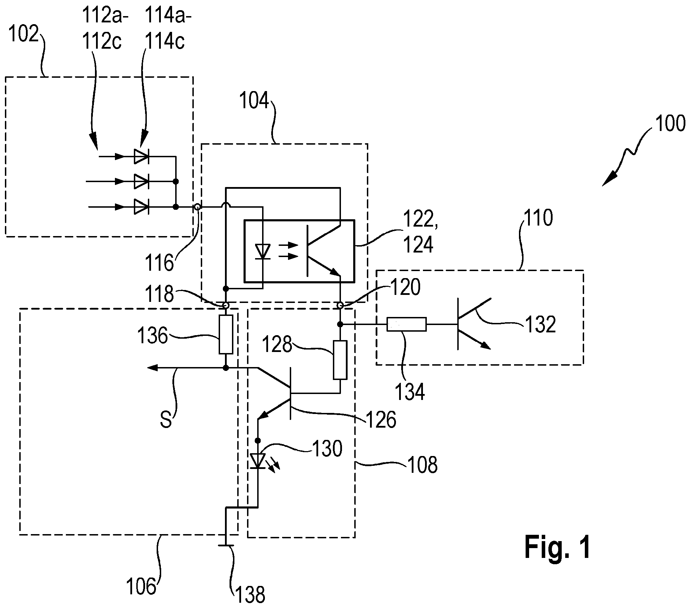

Die in Fig. 1 gezeigte Schaltungsanordnung 100 ist im vorliegenden Ausführungsbeispiel als Diagnoseschaltung (Fehlerauswertung) zum Einsatz in einer Sicherheitskette, z.B. bestehend aus einem Nothalt-Sensor, einem Sicherheitsschaltgerät und einem Aktor, in einer Automatisierungseinrichtung ausgebildet. Im vorliegenden Ausführungsbeispiel ist die Schaltungsanordnung 100 diskret aufgebaut.

Im vorliegenden Ausführungsbeispiel weist die Schaltungsanordnung 100 eine Eingangsbaugruppe 102, eine Diagnosebaugruppe 104, eine Startbaugruppe 106, eine Selbsthalteschaltung 108 und eine Einschaltverhinderungsbaugruppe 110 auf.

Die Eingangsbaugruppe 102 weist im vorliegenden Ausführungsbeispiel drei Signaleingänge 112a - 112c auf, von denen jeder mit einer Eingangsdiode 114a - 114c versehen ist. Die drei Signaleingänge 112a - 112c werden an einem Signaleingang 116 der Diagnosebaugruppe 104 zusammengeführt.

Die Diagnosebaugruppe 104 weist neben dem Signaleingang 116 einen Steuereingang 118 und einen Ausgang 120 auf. Der Steuereingang 118 ist mit der Startbaugruppe 106 elektrisch leitend verbunden, während der Ausgang 120 mit der Selbsthalteschaltung 108 elektrisch leitend verbunden ist. Ferner weist die Diagnosebaugruppe 104 ein Schaltelement 122 auf, bei dem es sich im vorliegenden Ausführungsbeispiel um einen Optokoppler 124 handelt. Der Optokoppler 124 ist im vorliegenden Ausführungsbeispiel eingangsseitig mit dem Signaleingang 116 und mit dem Steuereingang 118 und ausgangsseitig mit dem Ausgang 120 verbunden.

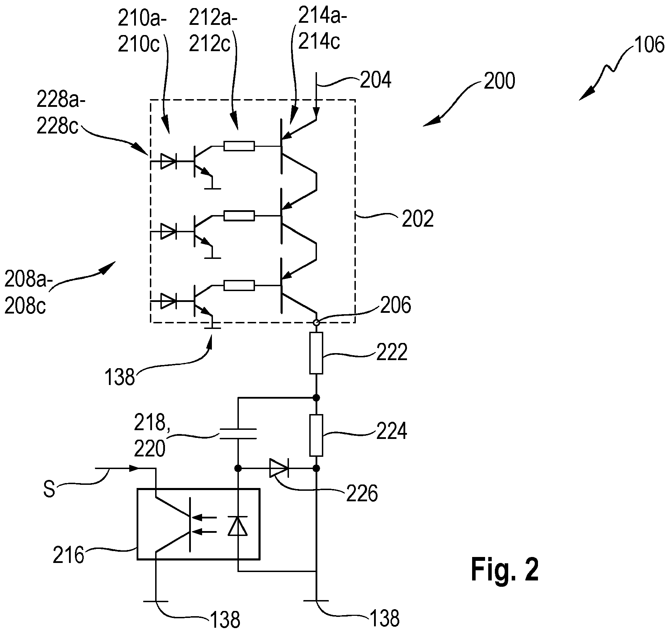

Die Startbaugruppe 106 weist im vorliegenden Ausführungsbeispiel einen ohmschen Widerstand 136 auf, der mit dem Steuereingang 118 verbunden ist. Der weitere Aufbau der Startbaugruppe 106 wird später unter Bezugnahme auf Fig. 2 erläutert.

Die Selbsthalteschaltung 108 weist im vorliegenden Ausführungsbeispiel einen Transistor 126, der im vorliegenden Ausführungsbeispiel durch einen Bipolartransistor gebildet ist, sowie einen ohmschen Widerstand 128 und eine Anzeigeeinrichtung 130 auf, die im vorliegenden Ausführungsbeispiel durch eine LED gebildet ist, auf. Die Basis des Transistors 126 ist über den ohmschen Widerstand 128 mit dem Ausgang 120 elektrisch leitend verbunden, während der Emitter des Transistors 126 im vorliegenden Ausführungsbeispiel mit der Anzeigeneinrichtung 130 elektrisch verbunden ist, die wiederum mit einem Masseanschluss 138 elektrisch leitend verbunden ist. Der Kollektor des Transistors 126 hingegen ist mit der Startbaugruppe 106 elektrisch leitend verbunden.

Die Einschaltverhinderungsbaugruppe 110 umfasst im vorliegenden Ausführungsbeispiel einen Transistor 132 sowie einen ohmschen Widerstand 134. Die Basis des Transistors 132 ist im vorliegenden Ausführungsbeispiel über den ohmschen Widerstand 134 mit dem Ausgang 120 und dem ohmschen Widerstand 128 der Selbsthalteschaltung 108 elektrisch leitend verbunden. Somit stellt im vorliegenden Ausführungsbeispiel die Einschaltverhinderungsbaugruppe 110 ein Signal bereit, das von weiteren Baugruppen (nicht dargestellt) verarbeitet werden kann, um ein Wiedereinschalten der Schaltungsanordnung 100 und/oder weitere Schaltungsteile zu verhindern.

Fig. 2 zeigt weitere Details des Aufbaus der Startbaugruppe 106.

Die Startbaugruppe 106 weist im vorliegenden Ausführungsbeispiel eine UND-Baugruppe 200 mit einem UND-Gatter 202 auf. Das UND-Gatter 202 weist im vorliegenden Ausführungsbeispiel drei Eingangsdioden 208a - 208c, drei Eingangstransistoren 210a - 210c sowie drei ohmsche Widerstände 212a - 212c und je drei weitere Transistoren 214a - 214c auf. Ferner weist die UND-Baugruppe 200 im vorliegenden Ausführungsbeispiel drei Eingänge 228a - 228c sowie einen Versorgungseingang 204 und einen Ausgang 206 auf. Jeder Eingang 228a - 228c ist mit je einer der Eingangsdiode 208a - 208c elektrisch leitend verbunden, die die Eingänge 228a - 228c mit der Basis des jeweiligen Transistors 210a - 210c elektrisch leitend verbindet. Der Emitter der jeweiligen Eingangstransistoren 210a - 210c ist mit dem Masseanschluss 138 elektrisch leitend verbunden, während der Kollektor der jeweiligen Eingangstransistoren 210a - 210c mit dem jeweiligen ohmschen Widerstand 212a - 212c elektrisch leitend verbunden ist, der wiederum eine elektrisch leitende Verbindung mit der Basis des jeweiligen Transistors 214a - 214c bildet. Ferner ist zu erkennen, dass der Versorgungseingang 204 elektrisch leitend mit dem Emitter des ersten Transistors 214a verbunden ist, der Kollektor des ersten Transistors 214a mit dem Emitter des zweiten Transistors 214b elektrisch leitend verbunden ist, und der Kollektor des zweiten Transistors 214b mit dem Emitter des dritten Transistors 214c elektrisch leitend verbunden ist, und der Kollektor des dritten Transistors 214c schließlich mit dem Ausgangsanschluss 206 elektrisch leitend verbunden ist. Somit bewirkt diese Anordnung der Transistoren 214a - 214c eine UND-Verknüpfung bzw. VerUNDung eines an den Eingängen 228a - 228c anliegenden Signals in der Form, dass ein an dem Versorgungseingang 204 anliegendes Signal zum Ausgang 206 nur weitergeleitet wird, wenn an allen Eingängen 228a - 228c ein Signal anliegt.

Der Ausgang 206 der UND-Baugruppe 200 ist mit einem ohmschen Widerstand 222 elektrisch leitend verbunden, der mit einem weiteren ohmschen Widerstand 224 einen Spannungsteiler für einen Energiespeicher 218 bildet, der im vorliegenden Ausführungsbeispiel durch einen Kondensator 220 gebildet ist. Der Energiespeicher 218 ist mit einem Optokoppler 216 eingangsseitig elektrisch leitend verbunden, sowie über eine Diode 226 mit dem ohmschen Widerstand 224 elektrisch leitend verbunden. Ferner ist der Energiespeicher 218 über die Diode 226 mit dem Masseanschluss 138 elektrisch leitend verbunden. Des Weiteren ist im vorliegenden Ausführungsbeispiel der Optokoppler 216 ausgangsseitig ebenfalls mit dem Masseanschluss 138 elektrisch leitend verbunden.

Nicht dargestellt ist, dass die Eingänge 228a - 228c der UND-Baugruppe 200 in Fig. 2 elektrisch leitend mit den Signaleingängen 112a- 112c der Eingangsbaugruppe 102 in Fig. 2 elektrisch gekoppelt sind.

Im Betrieb liegt an den drei Eingängen 228a - 228c ein Eingangssignal an. Somit wird der Energiespeicher 218, im vorliegenden Ausführungsbeispiel der Kondensator 220, über die Emitter-Kollektorstrecken der drei Transistoren 214a - 214, die ohmschen Widerständer 222, 224 und die Diode 226 aufgeladen.

Ein Start einer Diagnose wird ausgelöst, wenn einer der Signaleingänge 112a- 112c deaktiviert wird und somit kein Eingangssignal mehr anliegt. Damit wird zugleich einer der Eingänge 228a - 228 c deaktiviert. Der Start der Diagnose wird über die im Energiespeicher 218 gespeicherte elektrische Energie bewirkt, der sich nun über den ohmschen Widerstand 224 entlädt. Dadurch wird der Optokoppler 216 der Startbaugruppe 106 leitend und liefert ein Startsignal S. Durch das Startsignal wird das Eingangssignal des Schaltelements 122 der Diagnosebaugruppe 104, im vorliegenden Ausführungsbeispiel der Optokoppler 124, auf Masse gezogen. Das Schaltelement 122 wechselt dann von seinem deaktivierten Zustand in seinen aktivierten Zustand.

Wenn noch einer der Eingänge 112a- 112c aktiv ist, d.h. an wenigstens einem der Eingänge 112a- 112c liegt ein Eingangssignal an, wird über die jeweilige Diode 114a - 114c der Ausgang des Optokopplers 124 aktiv. Es fließt nun ein elektrischer Strom von den noch aktiven Eingängen 112a - 112c über den Optokoppler 124, den ohmschen Widerstand 136 und den leitenden Optokoppler 216 zum Masseanschluss 138. Zugleich fließt ein elektrischer Strom durch den nun leitenden Optokoppler 124 über den ohmschen Widerstand 128, der Basis-Emitterstrecke des Transistors 126 und der Anzeigeeinrichtung 130 zu dem Masseanschluss 138. Hierdurch wird die Kollektor-Emitterstrecke des Transistors 126 leitend, sodass nun ein elektrischer Strom von den noch aktiven Eingängen 112a - 112c durch den leitenden Optokoppler 124, den ohmschen Widerstand 136, der Kollektor-Emitterstrecke des Transistors 126 und der Anzeigeeinrichtung 130 zu dem Masseanschluss 138 fließt, wenn sich der Energiespeicher 218 entladen hat und damit der Optokoppler 216 nun sperrt.

Der Optokoppler 124 hält sich so lange über seinen Ausgang selber wie noch einer der Eingänge 112a- 112c aktiv ist. Diese Selbsthaltung wird dabei durch die Selbsthalteschaltung 108 mit dem Transistor 126 am Optokopplerausgang des Optokopplers 124 bewirkt und stellt sicher, dass sich der Optokoppler 124 nicht selbst den elektrischen Strom abschnürt. Die Anzeigeeinrichtung 130 zeigt dabei an, dass gerade eine Diagnose durchgeführt wird. Alternativ oder zusätzlich zu der Anzeigeeinrichtung 130 kann hier ein Signal zur weiteren Verarbeitung in weiteren Baugruppen (nicht dargestellt) der Schaltungsanordnung 100 abgezweigt werden. Solange die Schaltungsanordnung 100 aktiv ist, stellt die Wiedereinschaltverhinderungsbaugruppe 110 ein Signal bereit, das ein Wiedereinschalten der Schaltungsanordnung 100 und/oder weitere Schaltungsteile verhindert.

### BEZUGSZEICHENLISTE

- 100: Schaltungsanordnung
- 102: Eingangsbaugruppe
- 104: Diagnosebaugruppe
- 106: Startbaugruppe
- 108: Selbsthalteschaltung
- 110: Einschaltverhinderungsbaugruppe
- 112a: Signaleingang
- 112b: Signaleingang
- 112c: Signaleingang
- 114a: Eingangsdiode
- 114b: Eingangsdiode
- 114c: Eingangsdiode
- 116: Signaleingang
- 118: Steuereingang
- 120: Ausgang
- 122: Schaltelement
- 124: Optokoppler
- 126: Transistor
- 128: ohmscher Widerstand
- 130: Anzeigeeinrichtung
- 132: Transistor
- 134: ohmscher Widerstand
- 136: ohmschen Widerstand
- 138: Masse

- 200: UND-Baugruppe
- 202: UND-Gatter
- 204: Versorgungseingang
- 206: Ausgang
- 208a: Eingangsdiode
- 208b: Eingangsdiode
- 208c: Eingangsdiode
- 210a: Eingangstransistor
- 210b: Eingangstransistor
- 210c: Eingangstransistor
- 212a: ohmscher Widerstand
- 212b: ohmscher Widerstand
- 212c: ohmscher Widerstand

- 214a: Transistor
- 214b: Transistor
- 214c: Transistor
- 216: Optokoppler
- 218: Energiespeicher
- 220: Kondensator
- 222: ohmscher Widerstand
- 224: ohmscher Widerstand
- 226: Diode
- 228a: Eingang
- 228b: Eingang
- 228c: Eingang

- S: Startsignal

## Patentansprüche

1. Schaltungsanordnung (100) zur Überwachung einer Mehrzahl von Signaleingängen (112a -112c), mit einer Diagnosebaugruppe (104) und einer Startbaugruppe (106), wobei die Startbaugruppe (106) auf Erfassen eines deaktivierten Eingangssignals an einem der Signaleingänge (112a - 112c) durch die Schaltungsanordnung (100) ein Startsignal (S) erzeugend ausgebildet ist, die Startbaugruppe (106) mit der Diagnosebaugruppe (104) das Startsignal (S) zu der Diagnosebaugruppe (104) übertragend verbunden ist, und auf Erfassen des Startsignals (S) die Diagnosebaugruppe (104) aktivierbar ist, **dadurch gekennzeichnet, dass**
die Startbaugruppe (106) eine UND-Baugruppe (200) mit einem UND-Gatter (202) mit einer Mehrzahl von Eingängen (228a - 228c) aufweist, wobei die Eingänge (228a - 228c) der UND-Baugruppe (200) elektrisch leitend mit den Signaleingängen (112a - 112c) gekoppelt sind, und dass
eine Einschaltverhinderungsbaugruppe (110) vorgesehen ist, die ein Signal zum Verhindern eines Wiedereinschalten der Schaltungsanordnung (100) und/oder weitere Schaltungsteile bei aktivierter Diagnosebaugruppe (104) bereitstellt.

2. Schaltungsanordnung (100) nach Anspruch 1, wobei die Diagnosebaugruppe (104) ein Schaltelement (122) aufweist, das sich bei zumindest einem deaktivierten Signaleingang (112a - 112c) in einem ersten, aktivierten Schaltzustand befindet, und sonst in einem zweiten, deaktivierten Schaltzustand befindet.

3. Schaltungsanordnung (100) nach Anspruch 2, wobei das Schaltelement (122) einen Optokoppler (124) aufweist.

4. Schaltungsanordnung (100) nach Anspruch 2 oder 3, wobei die Startbaugruppe (106) einen Energiespeicher (218) aufweist, wobei sich bei dem sich entladenden Energiespeicher (218) das Schaltelement (122) in dem ersten, aktivierten Schaltzustand befindet.

5. Schaltungsanordnung (100) nach Anspruch 4, wobei der elektrische Energiespeicher (218) sich bei einem deaktivierten Signaleingang (112a - 112c) entladend ausgebildet ist.

6. Schaltungsanordnung (100) nach Anspruch 4 oder 5, wobei der elektrische Energiespeicher (218) ein Kondensator (220) ist.

7. Schaltungsanordnung (100) nach einem der vorstehenden Ansprüche, wobei die Diagnosebaugruppe (104) mit einer Selbsthalteschaltung (108) elektrisch leitend verbunden ist, um die Schaltungsanordnung (104) in Selbsthaltung zu halten.

8. Schaltungsanordnung (100) nach einem der vorstehenden Ansprüche, wobei die Signaleingänge (112a - 112c) einer Eingangsbaugruppe (102) der Schaltungsanordnung (100) zugeordnet sind, und die Eingangsbaugruppe (102) mit einem Signaleingang (116) der Diagnosebaugruppe (104) elektrisch leitend verbunden ist.

## Claims

1. A circuit arrangement (100) for monitoring a plurality of signal inputs (112a -112c), the circuit arrangement (100) comprising a diagnostic module (104) and a start module (106), wherein the start module (106) is configured to generate a start signal (S) in response to detecting a deactivated input signal at one of the signal inputs (112a - 112c) by the circuit arrangement (100), wherein the start module (106) is connected to the diagnostic module (104) to transmit the start signal (S) to the diagnostic module (104), and wherein upon detection of the start signal (S) the diagnostic module (104) can be activated, **characterized in that**
the start module (106) comprises an AND-module (200) comprising an AND-gate (202) with a plurality of inputs (228a - 228c), wherein the inputs (228a - 228c) of the AND-module (200) are electrically conductively coupled with the signal inputs (112a-112c), and that
a switch-on prevention module (110) is provided which provides a signal to prevent the circuit arrangement (100) and/or further circuit parts from being switched on again when the diagnostic module (104) is activated.

2. The circuit arrangement (100) according to claim 1, wherein the diagnostic module (104) comprises a switching element (122) which is in a first, activated switching state when at least one signal input (112a - 112c) is deactivated, and otherwise is in a second, deactivated switching state.

3. The circuit arrangement (100) according to claim 2, wherein the switching element (122) comprises an optocoupler (124).

4. The circuit arrangement (100) according to claim 2 or 3, wherein the start module (106) comprises an energy store (218), wherein the switching element (122) is in the first, activated switching state when the energy store (218) is discharging.

5. The circuit arrangement (100) according to claim 4, wherein the electrical energy store (218) is configured to be discharging when the signal input (112a - 112c) is deactivated.

6. The circuit arrangement (100) according to claim 4 or 5, wherein the electrical energy store (218) is a capacitor (220).

7. The circuit arrangement (100) according to one of the preceding claims, wherein the diagnostic module (104) is electrically conductively connected to a self-holding circuit (108) in order to hold the circuit arrangement (104) in self-holding.

8. The circuit arrangement (100) according to one of the preceding claims, wherein the signal inputs (112a - 112c) are assigned to an input module (102) of the circuit arrangement (100), and wherein the input module (102) is electrically conductively connected with a signal input (116) of the diagnostic module (104).

## Revendications

1. Agencement de circuit (100) permettant de surveiller une pluralité d'entrées de signal (112a à 112c), comprenant un sous-ensemble de diagnostic (104) et un sous-ensemble de démarrage (106), dans lequel le sous-ensemble de démarrage (106) est réalisé pour produire un signal de démarrage (S) par l'agencement de circuit (100) à la détection d'un signal d'entrée désactivé à l'une des entrées de signal (112a à 112c), le sous-ensemble de démarrage (106) est relié au sous-ensemble de diagnostic (104) pour transmettre le signal de démarrage (S) au sous-ensemble de diagnostic (104), et à la détection du signal de démarrage (S), le sous-ensemble de diagnostic (104) peut être activé,
**caractérisé en ce que** le sous-ensemble de démarrage (106) présente un sous-ensemble ET (200) comprenant une porte ET (202) dotée d'une pluralité d'entrées (228a à 228c), les entrées (228a à 228c) du sous-ensemble ET (200) étant couplées de manière électriquement conductrice aux entrées de signal (112a à 112c), et
**en ce qu'**un sous-ensemble d'empêchement de mise sous tension (110) est prévu qui fournit un signal pour empêcher une remise sous tension de l'agencement de circuit (100) et/ou d'autres composants de circuit lorsque le sous-ensemble de diagnostic (104) est activé.

2. Agencement de circuit (100) selon la revendication 1, dans lequel le sous-ensemble de diagnostic (104) présente un élément de commutation (122) qui, lorsqu'au moins une entrée de signal (112a à 112c) est désactivée, se trouve dans un premier état de commutation activé et se trouve sinon dans un deuxième état de commutation désactivé.

3. Agencement de circuit (100) selon la revendication 2, dans lequel l'élément de commutation (122) présente un optocoupleur (124).

4. Agencement de circuit (100) selon la revendication 2 ou 3, dans lequel le sous-ensemble de démarrage (106) présente un accumulateur d'énergie (218), l'élément de commutation (122) se trouvant dans le premier état de commutation activé lorsque l'accumulateur d'énergie (218) se décharge.

5. Agencement de circuit (100) selon la revendication 4, dans lequel l'accumulateur d'énergie électrique (218) est réalisé pour se décharger lorsqu'une entrée de signal (112a à 112c) est désactivée.

6. Agencement de circuit (100) selon la revendication 4 ou 5, dans lequel l'accumulateur d'énergie électrique (218) est un condensateur (220).

7. Agencement de circuit (100) selon l'une quelconque des revendications précédentes, dans lequel le sous-ensemble de diagnostic (104) est relié de manière électriquement conductrice à un circuit à verrouillage (108) afin de maintenir l'agencement de circuit (104) à l'état de verrouillage.

8. Agencement de circuit (100) selon l'une quelconque des revendications précédentes, dans lequel les entrées de signal (112a à 112c) d'un sous-ensemble d'entrée (102) sont attribuées à l'agencement de circuit (100), et le sous-ensemble d'entrée (102) est relié de manière électriquement conductrice à une entrée de signal (116) du sous-ensemble de diagnostic (104).
